Europäisches Patentamt

European Patent Office

Office européen des brevets

(11) Publication number: **0 118 554**
**B1**

# EUROPEAN PATENT SPECIFICATION

(45) Date of publication of patent specification: **13.01.88**

(51) Int. Cl.⁴: **H 01 L 33/00, H 01 L 31/02**

(21) Application number: **83903092.1**

(22) Date of filing: **08.09.83**

(86) International application number:
**PCT/GB83/00220**

(87) International publication number:
**WO 84/01057 15.03.84 Gazette 84/07**

(54) **OPTICAL DEVICE.**

(30) Priority: **09.09.82 GB 8225789**

(43) Date of publication of application:
**19.09.84 Bulletin 84/38**

(45) Publication of the grant of the patent:
**13.01.88 Bulletin 88/02**

(84) Designated Contracting States:
**AT BE CH DE FR LI LU NL SE**

(56) References cited:
**CA-A-1 108 900**
**DE-A-2 140 107**
**DE-A-2 633 086**
**FR-A-2 503 458**
**GB-A-2 052 785**
**US-A-4 257 058**

(73) Proprietor: **PLESSEY OVERSEAS LIMITED**
**Vicarage Lane**
**Ilford Essex IGI 4AQ (GB)**

(72) Inventor: **MABBITT, Allen, William**
**4 Bennett Drive**
**Warwick (GB)**
Inventor: **MORGAN, Peter, John**
**23 Butt Mead Blisworth**
**Northants (GB)**

(74) Representative: **Allen, Derek**
**The Plessey Company plc**
**Intellectual Property Department**
**Vicarage Lane**
**Ilford Essex, IG1 4AQ (GB)**

## Description

The present invention relates to optical devices and more particularly to the design and fabrication of low cost fibre optic link transmitter and receiver components.

A fibre optic link transmitter and receiver requires a light emitting diode (LED) or detector and a driver or amplifier circuit associated respectively therewith.

Patent Specification GB—A—2052785 discloses a device in which both a light active device and associated circuitry are provided on a single substrate in an encapsulated housing. One disadvantage of the solution provided in that specification is that the optoelectronic device requires careful encapsulation with an encapsulant of a specific refractive index to provide a high coupling efficiency to match an optical fibre to an optical device.

It is an object of the present invention to provide a low cost fibre optic link transmitter and receiver component which reduces these encapsulation difficulties.

The present invention provides an optical fibre receiver or transmitter component comprising light active device which may be a receiver or transmitter of light and an associated respective integrated circuit in which the integrated circuit and light active device are mounted on the same hybrid board in which the integrated circuit and the light active device are independently hermetically sealed in separate housings.

In a preferred embodiment the light active device is mounted in a recess in the hybrid board on which the integrated circuit substrate is mounted.

Preferably the integrated circuit is covered by a hermetically sealed cover to produce an integrated circuit package on the hybrid board. The light active device is preferably provided with a "pigtail" which is rigidly secured to the upper surface of the cover of the integrated package.

In a further preferred embodiment the optical device incorporates an optical connector for attachment to an optical cable.

Preferably the hybrid board is a thick film or a plurality of inter-connecting thick film circuits providing a complex connection pattern.

Embodiments of the present invention will now be described with reference to the accompanying drawings in which

Figure 1 shows a hybrid printed wiring board for the present invention,

Figure 2 shows the board of Figure 1 in a second stage of production with a cut out for an LED,

Figure 3 shows the board of Figures 1 and 2 in a third stage of production with the connection legs attached,

Figure 4 shows the board of Figures 1, 2 and 3 in a fourth stage of production,

Figure 5 shows the board of Figures 1 to 4 following a fifth stage of production to produce the optical fibre receiver and transmitter component according to the present invention,

Figure 6 shows a schematic view of a component according to the present invention in cut away form,

Figure 7 shows an alternative mounting for the light active device,

Figure 8 shows a perspective view of a transmitter module,

Figure 9 shows a perspective view of a receiver module,

Figure 10 shows a partial cross section of a first optical device assembly according to the present invention and,

Figure 11 shows a partial cross section of a second optical device assembly according to the present invention incorporating an optical connector.

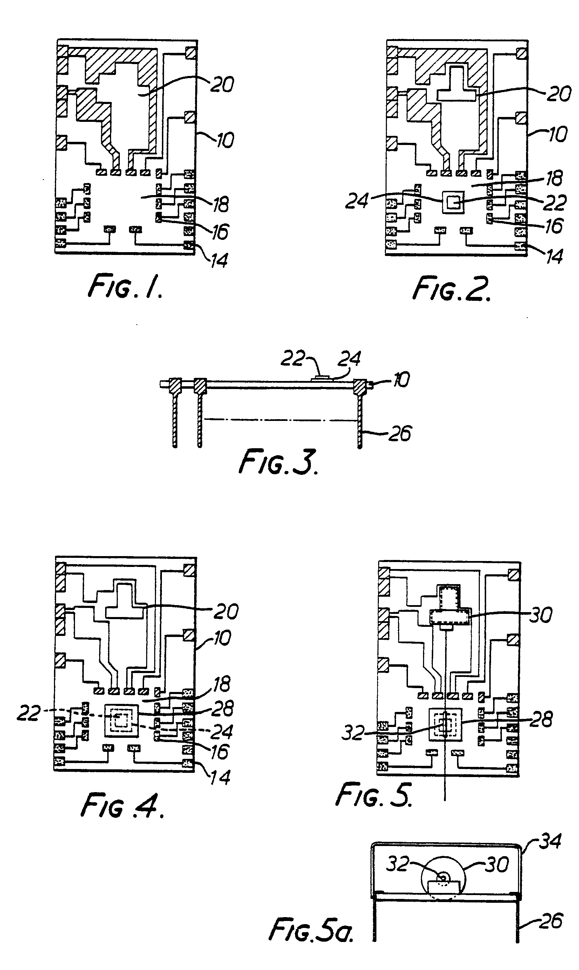

Referring now to Figure 1, a printed wiring board 10 has a number of tracks on its upper surface each connected to a first pad 14 and to a second smaller pad 16. The tracks and pads 16 are arranged to leave two areas 18, 20 clear for reasons which will become apparent with reference to Figure 2. Only a few of the tracks 12 which would be present on a practical component are shown for clarity. In a practical embodiment the board 10 is a ceramic thick film circuit of typical dimension 1,27 x 2,54 cm (½ inch x 1 inch).

In Figure 2 the area 20 has been cut out to give a shape suitable for later reception of an LED (see Figure 5). The invention will be described using an LED and associated integrated circuit. However a photodiode and an integrated circuit for amplification of a received signal may be substituted therefore. On the area 81 an integrated circuit chip 22 is mounted for control of the light emitted from LED 30 (see Figure 5). Electrical connections are made via gold or aluminium wires 23 of which one only is shown for clarity.

In a preferred embodiment the integrated circuit 22 is mounted on a ceramic thick film circuit 24 with appropriate conductor tracking to contact/bond pads for the integrated circuit and optical device (LED) attachment.

With reference to Figure 3 in a further stage the board 10 is equipped with connection legs 26 to enable the completed device to be mounted as a standard integrated circuit package.

In Figure 4 the integrated circuit is shown after bonding to the thick film circuit 24 and encapsulation with a ceramic inverted lid 28.

In Figure 5 the optical component 30, which may be a light emitting device (LED) or a light detection device (photodiode), is shown fixed to the board 10. This component is hermetically sealed within the package 30. The component package 30 may be soldered or bonded with a suitable adhesive to this board. The glass fibre tail 32 of the component 30 may be treated so as to be solderable to the upper surface of the ceramic lid 28 as shown at 32. Thus the optical component and electronic circuit are fixed rigidly to one another as shown in the elevation view of Figure 5a.

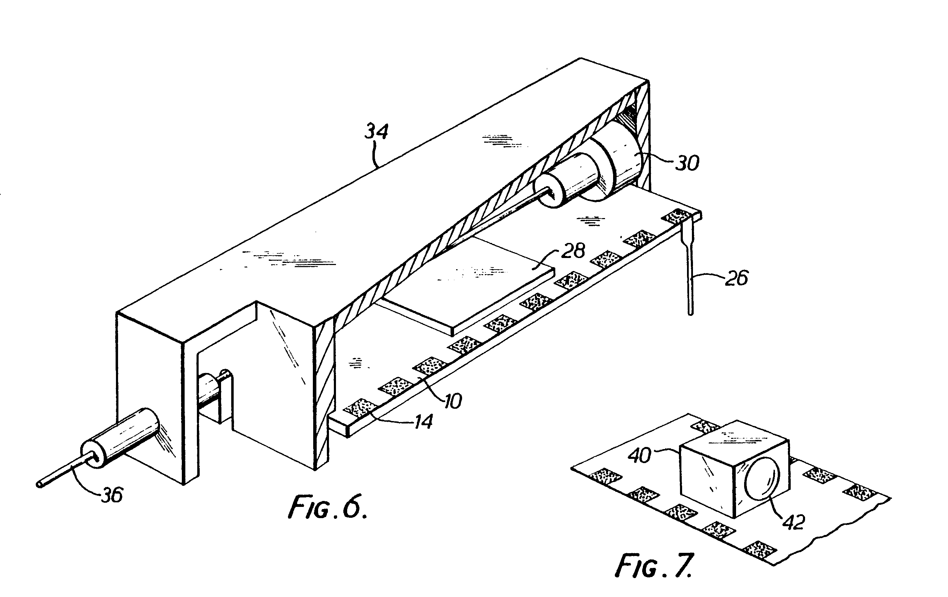

The optical component and integrated circuit hybrid may be encapsulated with a low cost plastic enclosure 34 which may or may not be sealed/ potted with resin. This allows cable attachment if required or alternatively a fibre pigtail 36 can be used as shown in Figure 6 or a connector attached to the fibre.

The mixture of hermetically sealed active components together with plastic encapsulation gives the advantage of high package environmental resistance, reliability and low cost packaging.

If higher performance receivers are required then high quality front-end components e.g. GaAs FET; Si JFET; Si MOSFET can be encapsulated under the ceramic lid 28 together with the integrated circuit 22.

The construction concept is applicable to any wavelength fibre optic component e.g. 0.8; 0.85; 0.9; 1.3; or 1.6 µm.

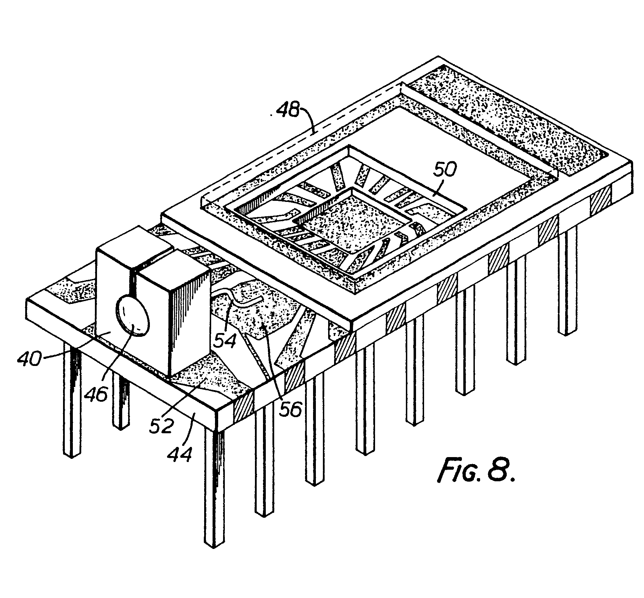

With reference to Figure 7, an alternative arrangement to the cut out 20 is shown. In this arrangement a heat sink block 40 (e.g. made of copper) is mounted on top of the board 10 for example by soldering on to a pad on the board and is provided with a hole 42 for reception of the optical component.

The arrangement of Figure 7 is further exemplified in Figure 8 which shows an optical transmitter device prior to selection of the light emitting diode and integrated circuit.

With reference to Figure 8 the block 40 is mounted onto a ceramic thick film circuit 44.

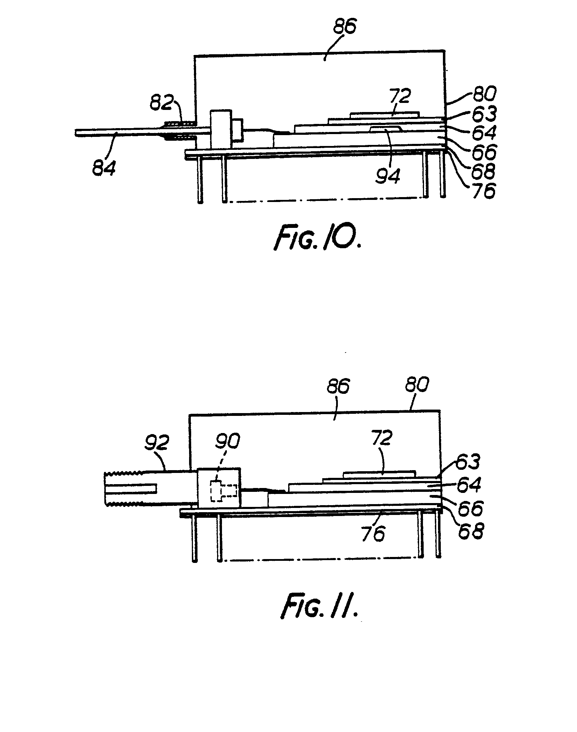

The light emitting device 46 is mounted in the block 40 and the optical fibre tail (not shown) may be secured to a plate 48 shown in dotted outline which provides a seal for a recess 50 within which the integrated circuit chip 22 (see Figure 2) is mounted. The lid 48 provides a hermetic seal for the integrated circuit 22 which may be further enforced by a secondary seal formed by filling the external enclosure with an encapsulant as described hereinafter with reference to Figures 10, 11.

The light emitting device 46 may be provided with power via track 52 and conductive block 40 and via a lead 54 to track 46.

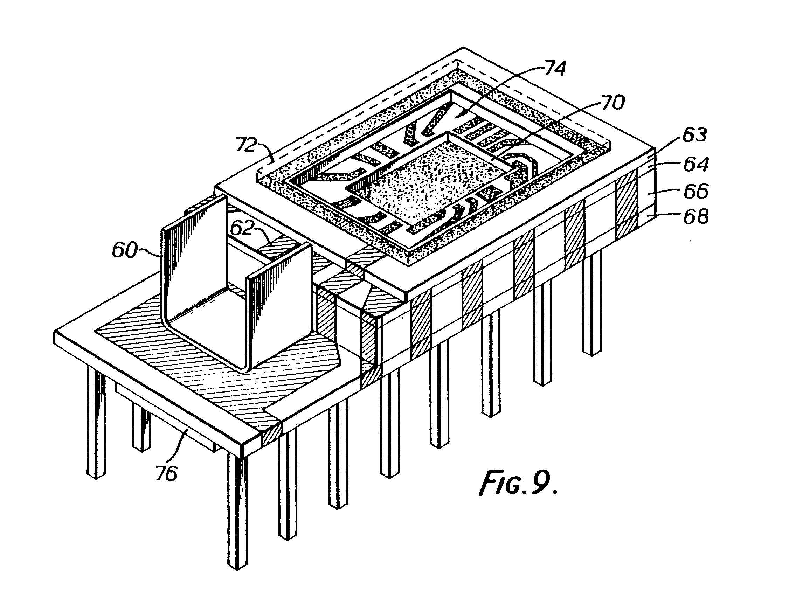

With reference to Figure 9 there is shown a receiver module prior to insertion of the photodiode and integrated circuit.

The photodiode is mounted in the saddle shaped structure 60 which structure provides a heat sink for the diode. The output lead of the diode is soldered to one of the pads, for example 62 on a ceramic thick film circuit layer 64.

The thick film circuit comprises a plurality of layers 63, 64, 66 and 68 which are joined together and enable a greater complexity of connections to the integrated circuit 22 (not shown) which is connected in a recess 70 in layer 66. As in Figure 8 a lid 72 indicated by dotted lines is provided to seal the enclosure 74. The sealing lid is again preferably made from gold plated kovar. A metal plate 76 may be provided underneath the thick film substrate 68 to provide further heat sinking. This plate may also be present in the previous embodiments.

With reference now to Figure 10 a partial cross section through Figure 9 is shown including a top cover 80 and a bush 82 which supports the optical fibre "pigtail" 84. The space 86 within the cover 80 may be filled with an encapsulant material to provide additional environmental protection.

With reference to Figure 11 the hybrid thick film structure is as for Figure 10 but instead of the bush 82 and "pigtail" 84 the light emitting diode or the photodiode 90 (shown dotted) is enclosed in one part of an optical connector 92. Thus connection can be made by use of the other mating part of the optical connector.

Again as in Figure 10 the space 86 may be filled with an encapsulating material which provides an additional environmental protection for the integrated circuit 94 and for the connector arrangement. The integrated circuit is therefore hermetically sealed as a stand alone component, it is sealed within the enclosure formed by the ceramic thick film circuit and the lid 72, which enclosure may in all cases be partially or wholly filled with an encapsulant material and it is protected by the top cover 80 and by any encapsulant 86 introduced therein. The completed device is therefore extremely rugged and environmentally well protected.

## Claims

1. An optical device for transmitting or receiving light via an optical fibre (32) including a light active device (30) and an associated electrical circuit which is at least partially included in an integrated circuit (22) in which the integrated circuit (22) and light active device (30) are mounted on the same hybrid board (10) characterised in that the light active device (30) is hermetically sealed in a first housing and the integrated circuit (22) is independently hermetically sealed in a second housing (28), at least one wall of said second hoousing being formed by the hybrid board (10).

2. An optical device as claimed in claim 1 in which the hybrid board (10) comprises one or more thick film circuits (24) to provide connection between output pins (14) and said integrated circuit (22) and said light active device (30).

3. An optical device as claimed in claim 2 in which there are a plurality of thick film circuits and in which the integrated circuit is mounted within a recess (50) formed in the plurality of thick film circuits and in which the enclosure formed in said plurality of thick film circuits is hermetically sealed by a lid (48).

4. An optical device as claimed in claim 3 in which the light active device is mounted in a thermally conductive mount (40) secured to an outer one (44) of said plurality of thick film circuits.

5. An optical device as claimed in claim 4 in which a metal plate (76) is secured to the outside surface of the outer one (68) of said plurality of thick film circuits (63, 64, 66, 68) to provide additional heat sinking for the light active device (30).

6. An optical device as claimed in claim 3 in which the plurality of thick film circuits is provided with a cover (34), in which the cover provides a bush (figure 6) for protection of a pigtail optical fibre (36) connected to said light active device (30).

7. An optical device as claimed in claim 3 in which the light active device (90) is an integral part of an optical fibre connector (92), which is secured to one of said plurality of thick film circuits (68).

8. An optical device as claimed in claim 3 in which a portion of the optical fibre (32) is attached to the lid of the second housing (28).

## Patentansprüche

1. Optisches Bauteil, um Licht über eine optische Faser (32) auszusenden oder zu empfangen, ein lichtaktives Bauteil (30) und einen zugeordneten elektrischen Schaltkreis umfassend, welches mindestens teilweise in einen integrierten Schaltkreis (22) einbezogen ist, wobei der integrierte Schaltkreis (22) und das lichtaktive Bauteil (30) auf derselben Hybridplattine (10) angeordnet sind, dadurch gekennzeichnet, dass das lichtaktive Bauteil (30) hermetisch in einem ersten Gehäuse gekapselt ist und der integrierte Schaltkreis (22) unabhängig davon in einem zweiten Gehäuse (28), wobei mindestens eine Wand besagten zweiten Gehäuses durch die Hybridplattine (10) gebildet ist.

2. Optisches Bauteil nach Anspruch 1, in welchem die Hybridplattine (10) einen oder mehrere Dickfilmkreise (24) umfasst, um Verbindung zwischen Ausgangsanschlüssen (14) und besagtem integrierten Schaltkreis (22) und besagtem lichtaktivem Bauteil (30) herzustellen.

3. Optisches Bauteil nach Anspruch 2, in welchem eine Mehrzahl von Dickfilmkreisen vorgesehen ist, und in welchem der integrierte Schaltkreis in einer Aussparung (50) angeordnet ist, die in der Mehrzahl der Dickfilmkreise geformt ist, und in welchem die Einlage, ausgebildet in besagter Mehrzahl von Dickfilmkreisen, hermetisch durch eine Abdeckung (48) verschlossen ist.

4. Optisches Bauteil nach Anspruch 3, in welchem das lichtaktive Bauteil in einer thermisch leitenden Anordnung (40) montiert ist, welche an einem äusseren (44) besagter Mehrzahl von Dickfilmkreisen befestigt ist.

5. Optisches Bauteil nach Anspruch 4, in welchem eine Metallplatte (76) an der äusseren Oberfläche des äusseren (68) besagter Mehrzahl von Dickfilmkreisen (63, 64, 66, 68) befestigt ist, um eine weitere Wärmesenke für das lichtaktive Bauteil (30) zu ergeben.

6. Optisches Bauteil nach Anspruch 3, in welchem die Mehrzahl von Dickfilmkreisen mit einer Abdeckung (34) versehen ist, in welchem die Abdeckung eine Buchse (Fig. 6) bereitstellt, zum Schutze einer biegsamen optischen Faser (36), welche mit besagtem lichtaktiven Bauteil (30) verbunden ist.

7. Optisches Bauteil nach Anspruch 3, in welchem das lichtaktive Bauteil (90) ein integrierter Teil eines optisches Faseranschlusses (92) ist, welcher an einem der besagten Mehrzahl von Dickfilmkreisen (68) befestigt ist.

8. Optisches Bauteil nach Anspruch 3, in welchem ein Teil der optischen Faser (32) an der Abdeckung des zweiten Gehäuses (28) befestigt ist.

## Revendications

1. Dispositif optique destiné à émettre ou recevoir de la lumière par l'intermédiaire d'une fibre optique (32), comprenant un dispositif photoactif (30) et un circuit électrique associé qui est au moins partiellement inclus dans un circuit intégré (22), dans lequel le circuit intégré (22) et le dispositif photoactif (30) sont montés sur la plaquette hybride (10), caractérisé en ce que le dispositif photoactif (30) est enfermé hermétiquement dans un premier boîtier et le circuit intégré (22) est enfermé hermétiquement et indépendamment dans un second boîtier (28), une paroi au moins du second boîtier étant formée par la plaquette hybride (10).

2. Dispositif optique selon la revendication 1, dans lequel la plaquette hybride (10) comporte un ou plusieurs circuits (24) à couches épaisses destinés à assurer la connexion entre des broches de sortie (14) et le circuit intégré (22) et le dispositif photoactif (30).

3. Dispositif optique selon la revendication 2, dans lequel plusieurs circuits à couches épaisses sont présents et dans lequel le circuit intégré est monté dans une cavité (50) formée dans les circuits à couches épaisses, et dans lequel l'enceinte formée dans les circuits à couches épaisses est fermée hermétiquement par un couvercle (48).

4. Dispositif optique selon la revendication 3, dans lequel le dispositif. photoactif est monté dans un dispositif (40) conducteur de la chaleur fixé à un circuit externe (44) des circuits à couches épaisses.

5. Dispositif optique selon la revendication 4, dans lequel une plaque métallique (76) est fixée à la surface externe du circuit externe (68) des circuits à couches épaisses (63, 64, 66, 68) afin qu'un radiateur supplémentaire soit formé pour le dispositif photoactif (30).

6. Dispositif optique selon la revendication 3, dans lequel les circuits à couches épaisses sont munis d'un couvercle (34), dans lequel le couvercle forme un manchon (figure 6) destiné à protéger une extrémité de fibre optique (36) raccordée au dispositif photoactif (30).

7. Dispositif optique selon la revendication 3, dans lequel le dispositif photoactif (90) est solidaire d'un connecteur (92) à fibre optique qui est fixé à l'un des circuits à couches épaisses (68).

8. Dispositif optique selon la revendication 3, dans lequel une partie de la fibre optique (32) est fixée au couvercle du second boîtier (28).

FIG. 1.

FIG. 2.

FIG. 3.

FIG. 4.

FIG. 5.

FIG. 5a.

Fig. 6.

Fig. 7.

FIG. 8.

Fig.9.

63
64
66
68
70
74
72
62
60
76

FIG. 10.

FIG. 11.